# EUROPEAN PATENT SPECIFICATION

(11) **EP 2 963 825 B1**
(45) Date of publication and mention of the grant of the patent: **10.05.2017**
(21) Application number: 15173752.5
(22) Date of filing: 25.06.2015
(51) Int. Cl.: H03L 7/00, H04B 1/04, H03C 1/62, H03L 7/02, H03L 7/18, H04B 1/38, H04B 7/00, H04L 25/49

(54) **OSCILLATOR CIRCUITS AND METHOD TO COMPENSATE THE FREQUENCY PULLING**
OSZILLATORSCHALTUNGEN UND VERFAHREN ZUR KOMPENSATION DES MITZIEHEFFEKTS
CIRCUITS OSCILLATEURS ET PROCÉDÉ POUR COMPENSER L'ENTRAÎNEMENT DE FRÉQUENCE

(30) Priority: 30.06.2014 IT MI20141189
(43) Date of publication of application: 06.01.2016
(73) Proprietor: STMicroelectronics S.r.l., 20864 Agrate Brianza (MB) (IT)
(72) Inventor: Scuderi, Angelo, I-95030 Nicolosi (Catania) (IT); Calcagno, Antonino, I-98168 Messina (IT); Scaccianoce, Salvatore, I-95128 Catania (IT)
(74) Representative: Bosotti, Luciano

(56) References cited:
- US-A1- 2006 202 767
- US-A1- 2012 119 942

## Description

### TECHNICAL FIELD

The disclosure relates to electronic oscillator circuits with frequency pulling compensation.

More particularly, the disclosure relates to electronic oscillator circuits, as direct conversion circuits having a local oscillator, a modulator with a pulse modulation signal and a power amplifier integrated in the same semiconductor substrate in particular for automotive and industrial systems applications.

### BACKGROUND OF THE INVENTION

As it is known, in silicon-chip implementations comprising a local oscillator and a power amplifier the injection of a periodic signal leads to locking or pulling phenomena.

The electronic circuits, as RF transceivers or as device for frequency synthesis techniques suffer from frequency pulling when a pulsed modulation signal is applied.

During the pulses transmission, in the RF transceiver having a transmitter and a receiver, the coupling of the power amplifiers and local oscillators in the same substrate affects the transmitted signal by generating an oscillation frequencies change between the receiver local oscillator and the transmitted signal frequency.

The effect of the undesirable frequency deviation in the transmitted signal occurs in a loss of correlation that increases the errors in the demodulated signal from the receiver.

Any switching element in an electronic circuit having a local oscillator can generate similar effects by causing pulling effects.

In particular, the disclosure relates to silicon integrated circuit, and the application field are: integrated circuits on semiconductors: e.g. CMOS, Bipolar, BiCMOS technologies, Radio frequency and Microware applications, Circuits composed of oscillators, power amplifiers and/or receivers, Integrated Circuits for radar applications using pulse modulation techniques.

### DISCUSSION OF THE RELATED ART

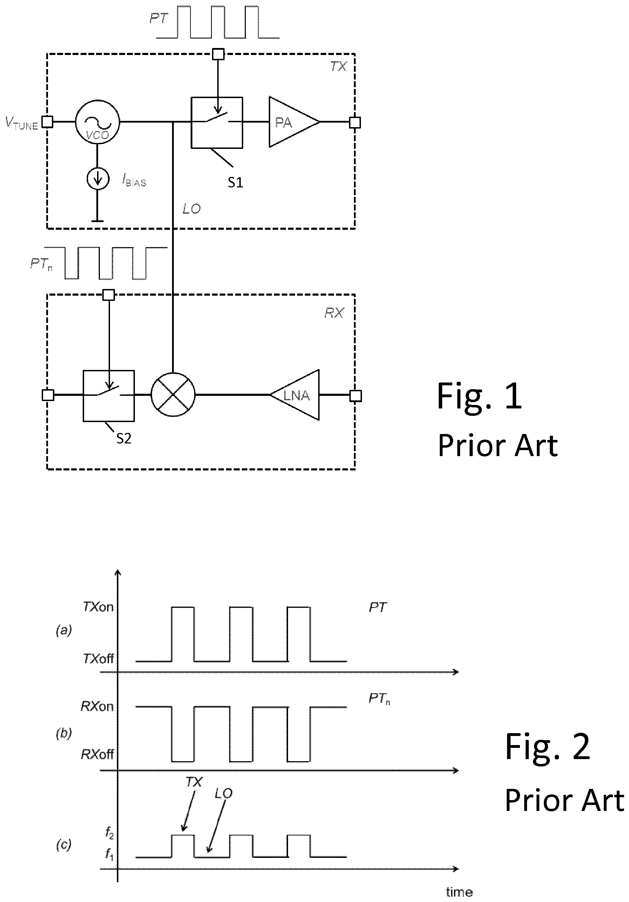

A conventional transceiver is shown in Figure 1 and comprises a transmitter Tx and a receiver Rx. The transmitter Tx comprises a local oscillator LO that generates a radio frequency carrier f1 which is modulated by a first switch S1 and amplified by a power amplifier PA. The transmitted signal is a train of pulses modulated by using frequency, amplitude, pulse time duration, pulse position or other modulation techniques. The received signal, received from the receiver Rx, is amplified by a low-noise amplifier LNA and down-converted to the intermediate frequency IF by means of an interposed adder and by using a second switch S2.

The receiver Rx can comprise a further interposed switch to blind the receiver Rx when the transmitter Tx generates the train of pulses modulated. The switches, S1 and S2, are driven by a pilot signal PT and its complementary pilot signal PTn, respectively, as shown in FIG. 2.

Known solutions provide local oscillator LO by controlling the tuning voltage V_{TUNE} through an open loop approach or PLL systems.

These solutions, that are convenient under various aspects, suffer from same drawbacks. In fact, the compensation of the pulling frequency is reduced in high frequency oscillator circuits, when the frequency is approximately of 24GHz and or 77-79 GHz, as radar systems, having fast pulses. The local oscillator LO is subjected to the power coupling and/or impedance loading of the power amplified PA that generates leakage current through the substrate or through circuit pathways of the chip.

This leakage current affects the oscillation frequency of the local oscillator LO wider than the ideal frequency during the open (ON) and close (OFF) phases of the switch modulator S1. This pulling effect leads to a source of error for the transmitted signal which is found in a frequency deviation Δfer = f1 - f2, from f1 frequency of carrier signal to f2 during the pulses transmission, close phase of the switch modulator, as shown in Figure 2.

Moreover, it is worth to observe that even a control system as a phase Lock loop PLL cannot be used to compensate the frequency deviation for high-frequency applications wherein fast pulses are provided.

The document "A study of injection locking and pulling in oscillators" by Razavi B. IEEE Journal of Solid-Sate Circuits, vol. 39, 2004, pages 1415-1424, relates to an RF transceiver TX, wherein the output signal of the power amplifier PA contains large spectral components in the vicinity of ω_{L0}, leaking through the package and the substrate to the local oscillator LO causing frequency deviation. The leakage of the power amplifier PA could be considered as a sinusoidal injection current that modifies the frequency where the local oscillation LO occurs.

It may be particularly desirable to improve the architecture of the local oscillator LO in order to reduce the pulling effect in an efficiency mode during high frequency modulation.

It would be desirable to obtain a transceiver having frequency coherence between the transmitted/received signals and the carrier signal in a simple implementation.

Moreover, a versatile solution that can be used in oscillator circuits integrate on semiconductors e.g. Cmos, Bipolar, BiCMos technologies, radio frequency and microwave applications and integrated circuits for radar applications using pulse modulation techniques, would be desirable.

Furthermore, it may be desirable to obtain a solution to increase performances of current radar systems wherein high power pulses are transmitted that are used, in particular, in the automotive and industrial applications.

US2006202767 and US2012119942 disclose conventional oscillators with frequency control based on a feedback signal.

### SUMMARY OF THE INVENTION

According to an embodiment, the disclosure provides an oscillator circuit that comprises a local oscillator configured to generate a carrier signal having a tunable frequency, a first modulator and a power amplifier couple in cascade to the local oscillator and configured to generate an output signal, the first modulator configured to be activated from a first modulating signal having a first modulating frequency defining alternatively states ON and states OFF of said first modulator, the oscillator circuit further comprising:
- an estimator unit configured to receive the carrier signal during a time window and to detect an estimated frequency variation of the carrier signal during the states ON and the states OFF of the first modulator,
- a compensation unit comprising a second modulator and configured to generate a compensation signal proportional to the estimated frequency variation and modulated with a second modulating frequency, the second modulating frequency being substantially the same of the first modulating frequency, the compensation signal being adapted to be added to a bias signal of the local oscillator in order to tune the tunable frequency.

According to one aspect, the compensation unit may also comprises a logic unit coupled to a second modulator, the logic unit being configured to receive the estimated frequency variation and to define a pre-compensation signal, the second modulator configured to modulate the pre-compensation signal by a second modulating signal having the second modulating frequency.

Moreover, the logic unit may be configured to generate an output digital signal, and the compensation unit further comprises a digital to analog converter configured to receive the output digital signal and to generate the pre-compensation signal. The compensation unit comprises a Finite State Machine.

Furthermore, the oscillator circuit may include an input terminal coupled to a voltage source by a first adder, the first adder being configured to generate a voltage compensation signal by summing the bias voltage signal generated by the voltage source and the voltage compensation signal generated by the compensation unit.

Also, the local oscillator may comprise an input bias terminal coupled to a current source by a second adder, the second adder being configured to generate a current compensation signal by summing the bias current signal generated by the current source and the current compensation signal generated by the compensation unit.

According to another embodiment, the disclosure provides a transceiver comprises a transmitter and a receiver, the transmitter being configured according to an oscillator circuit and the receiver comprising a low-noise amplifier coupled to a demodulator with an interposed adder, the interposed adder being configured to receive the carrier signal of the local oscillator and being coupled to the demodulator driven by a demodulating signal, the demodulating signal having the same frequency of the first modulating signal and being a complementary signal with respect to the first modulating signal.

According to one embodiment, the disclosure provides a method to compensate the frequency pulling in an oscillator circuit comprising: generating a carrier signal by a local oscillator operative to a tunable frequency, modulating the carrier signal with a first modulating signal having a first frequency by obtaining a modulated carrier signal and amplifying the modulated carrier signal to generate an output signal; and further comprising: processing the carrier signal in a time window and with a clock signal defining, during said time window, first time intervals and second time intervals, estimating a first estimated frequency during said first time intervals and a second estimated frequency during said second time intervals, calculating an estimating frequency variation of said carrier signal as a difference between said first estimated frequency and said second estimated frequency, generating a pre-compensation signal setting from the estimated frequency variation value, modulating the pre-compensation signal with a second modulating signal by obtaining a compensation signal, said second modulating signal having the same frequency of the first modulating signal, adding the compensation signal to a bias signal of said local oscillator for tuning the tunable frequency.

According to one aspect, the processing of the carrier signal further comprises providing the first modulating signal as said clock signal, defining a logic state of the local oscillator by using a previous logic state of the local oscillator and by elaborating the estimated frequency variation value, generating an output digital signal by using the defined logic state of the local oscillator, converting the output digital signal in an analog pre-compensation signal.

According to one other embodiment, the disclosure provides a method to compensate the frequency pulling in a transceiver comprising: generating a transmitter and generating a receiver receiving an input signal and the carrier signal generated by the local oscillator of the transmitter for generating a receiving signal, and demodulating the receiving signal by using a demodulator switch driven by a demodulating signal, providing the demodulating signal having substantially the same frequency of the first modulating signal and being a complementary signal with respect to the first modulating signal.

### BRIEF DESCRIPTION OF THE DRAWINGS

Figures 1 and 2 are respectively a schematic block diagram and wave forms of corresponding electric components according to an embodiment of the prior art;
Figure 3 shows a schematic block diagram of a transceiver according to a first embodiment;
Figure 4 shows a schematic block diagram of a transceiver according to a second embodiment;
Figure 5 shows characteristics of experimental behaviors of the oscillator circuit of Figure 3 having an estimated frequency variation of about 4 Mhz and 33 kHz, respectively.

### DETAILED DESCRIPTION OF THE PREFERRED EMBODIMENTS

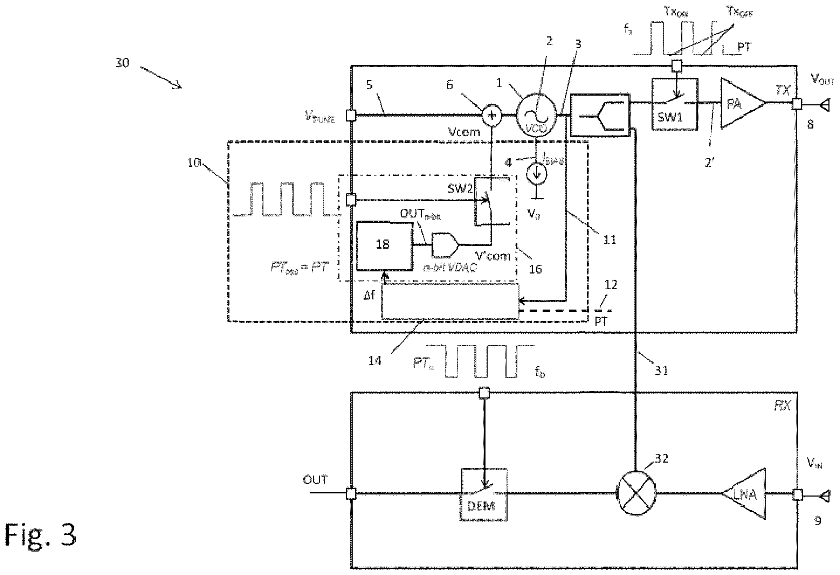

An oscillator circuit, according to one embodiment, is generally referred to by numeral 30, as shown in Fig. 3 of the drawings.

The oscillator circuit 30 is a silicon integrated circuit and in a first embodiment is a transceiver and comprises a transmitter Tx and a receiver Rx that are implemented in the same substrate.

The following description refers to a transceiver 30 configured with the necessary hardware and software to execute radar applications using pulse modulation techniques.

The transmitter Tx transmits an output signal V_{OUT} that is a train of pulses modulated and the receiver Rx receives an input signal V_{IN} that is a return signal of the output signal V_{OUT} like an echo. The correlation between the input signal V_{IN} and the output signal V_{OUT} allows defining correlation information and monitoring parameters of the environment around the transceiver 30.

The transmitter Tx comprises a local oscillator 1, which is configured to receive a bias voltage signal V_{TUNE} and a bias current signal I_{BIAS} and to generate a carrier signal 2 having a tunable frequency fₜ.

The transmitter Tx comprises a first modulator SW1 and a power amplifier PA configured to be couple in cascade to the local oscillator 1 and configured to generate the output signal V_{OUT}.

The first modulator SW1 is configured to be coupled to an output terminal 3 of the local oscillator 1 to receive the carrier signal 2 in order to generate a modulated carrier signal 2'. In this embodiment, the carrier signal 2 and consequently the output signal V_{OUT} are radio frequency signals.

The first modulator SW1 is configured to be activated from a first modulating signal PT having a first modulating frequency f1 that defines alternatively a state ON and a state OFF of the first modulator SW1.

The transmitter Tx further comprises a control block 10 configured to receive the carrier signal 2 during a time window ΔTx. The time window ΔTx comprises a predefined number of first time intervals Tx_{ON} that correspond to a state ON of the first modulator SW1, and a predefined number of second time intervals Tx_{OFF} that correspond to a state OFF of the first modulator SW1.

The control block 10 comprises an estimator unit 14 that is configured to receive and process the carrier signal 2 during the time window ΔTx and detect an estimated frequency variation Δf of the carrier signal 2 during said first time intervals Tx_{ON} and said second time intervals Tx_{OFF}.

According to an embodiment, the transmitter Tx comprises a compensation unit 16 that is configured to generate a voltage compensation signal Vcom proportional to the estimated frequency variation Δf.

In particular, the compensation unit 16 is configured to generate a pre-compensation voltage signal V'com that is proportional to the estimated frequency variation Δf of the carrier signal 2 and that is modulated from a second modulator SW2 by a second modulating signal PTosc in order to obtain the voltage compensation voltage Vcom.

The second modulating signal PTosc has a second modulating frequency f2 that is substantially the same of the first modulating frequency f1 of the first modulating signal PT. In particular, the second modulating signal PTosc can be a signal having the same frequency of the first modulating signal PT with a different duty-cycle.

The transmitter Tx is further configured to add the voltage compensation signal Vcom to the bias voltage signal VTUNE of the local oscillator 1 in order to tune the tunable frequency fₜ.

The estimator unit 14 is configured with the necessary hardware and software to define a frequency counter.

According to one embodiment, the estimator unit 14 comprises an input terminal 11 configured to be selectively coupled to the output terminal 3 of the local oscillator 1 during the time window ΔTx. The input terminal 11 may comprise a timing switch that is not included in the figure. The estimator unit 14 comprises a further input terminal 12 (dot line) that is configured to receive, as a clock signal, the first signal PT in order to determinate the first time intervals TX_{ON} and the second time intervals TX_{OFF} of the first modulator SW1.

The estimator unit 14 is configured to monitor during the time window ΔTx the carrier signal 2 and to estimate a first estimated frequency F1_{ON} during the first time intervals TX_{ON}, that correspond to the state ON of the first modulator SW1, and a second estimated frequency F2_{OFF} during the second time intervals Tx_{OFF}, that correspond to the state OFF of the first modulator SW1.

The estimator unit 14 is configured to calculate the estimated frequency variation Δf as difference between the first estimated frequency F1_{ON} and the second estimated frequency F2_{OFF}

The compensation unit 16 comprises a logic unit 18 configured to define a model of the local oscillator 1.

The logic unit 18 is configured to receive from the estimated unit 14 the estimated frequency variation Δf and to define an output digital signal OUT_{n-bit} adapted to generate the proportional pre-compensation voltage signal V'com.

According to one embodiment, the logic unit 18 is a Finite State Machine that receives the frequency variation Δf and sets a proper value of n-bit DAC which defines the output digital signal OUT_{n-bit} according to a state N of the local oscillator 1. In particular, the Finite State Machine 18 is configured to determine the state N of the local oscillator 1 with respect to the estimated frequency variation Δf and to a previous state N-1 of the local oscillator 1 that is stored in a memory.

The compensation unit 16 further comprises a digital to analog voltage converter VDAC configured to receive the output digital signal OUT_{n-bit} and to generate the pre-compensation voltage signal V'com that has a proportional voltage variation and corresponding to [±0.5*(2ⁿ-1)*ΔV], wherein the ΔV is a predefined voltage step value.

The second modulator SW2 is configured to receive and to synchronize the voltage compensation signal Vcom by the first modulating signal PT.

The local oscillator 1 comprises an input terminal 5 that receives a tuning voltage V_{TUNE} from a tuning voltage source. A first adder 6, i.e. a voltage summing circuit, receives by the input terminal 5 the tuning voltage V_{TUNE} and the voltage compensation signal Vcom that is set by the control block 10 according to the amount of the frequency pulling.

In this way, the voltages to drive variable capacitors (junction or MOS semiconductors) are combined with to the bias voltage signal V_{TUNE} or resonator in order to tune the tunable frequency fₜ and obtain a substantially stable oscillation frequency of the output signal V_{OUT} during the state ON and the state OFF of the first modulator SW1.

It is worth to observe that the control block 10, during an initial calibration that corresponds to one or more time window ΔTx, performs an adjusting of the oscillator frequency of the local oscillator 1 in order to minimize the frequency deviation of the carrier signal 2, between first time intervals TX_{ON} and second time intervals TX_{OFF} of the first modulator SW1. After the initial calibration, the timing switch is disconnected to the output terminal 3 of the local oscillator 1 but the compensation signal Vcom is generated 1 during the operation time of the local oscillator 1 for adjusting of the oscillator frequency of the local oscillator in order to compensate the pulling frequency phenomenon.

The receiver Rx comprises a low-noise amplifier LNA coupled to a demodulator DEM with an interposed adder 32. The adder 32 is configured to receive from the local oscillator 1 the carrier signal 2 by an interposed terminal 31 that is coupled to the output terminal 3. The demodulator DEM is driven by a demodulating signal PT_{N}, that is a complementary signal with respect to the first modulating signal PT and that has the same demodulating frequency f_{D} of the first modulating signal PT.

The receiver Rx receives the input signal V_{IN} that is amplified by the low-noise amplifier LNA and mixed with the carrier signal 2 and further demodulated by the demodulator DEM to generate an output data signal OUT.

In this way, rectifying the tunable frequency fₜ of the local oscillator 1, the input signal V_{IN}, the output signal V_{OUT} and the currier signal 2 have the same frequency and the frequency pulling phenomenon is reduced.

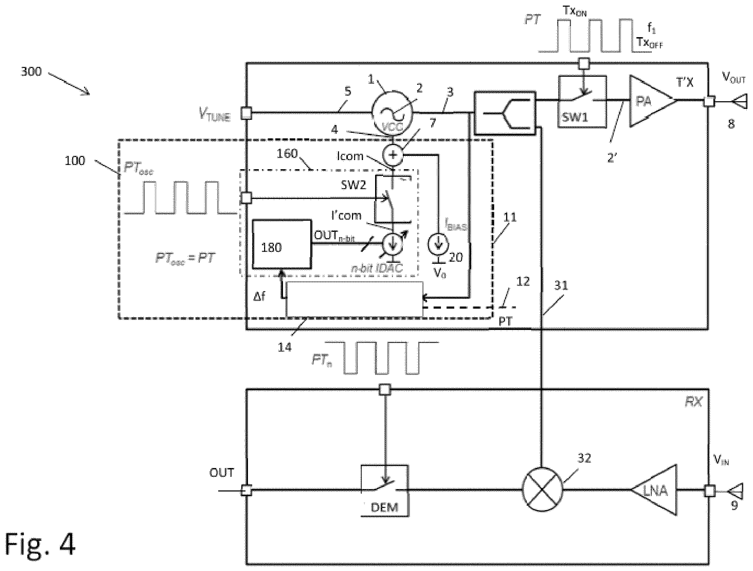

According to another embodiment, as shown in Fig. 4 of the drawings, and in a dual mode with respect the above described embodiment, a transceiver 300 comprises a transmitter Tx' and a receiver Rx. The transceiver corresponds substantially to the above described transceiver 30 and in the following description only the differences will be described and parts and details already described and having the same structure and function will be identified by the same signs and reference numbers.

In particular, the transmitter Tx' comprises a control block 100 configured to modify the bias current signal I_{TUNE} of the local oscillator 1 using a current compensation signal Icom.

The transmitter Tx' comprises the local oscillator 1 which is configured to receive a bias voltage signal V_{TUNE} and a bias current signal I_{BIAS} and to generate a carrier signal 2 having a tunable frequency fₜ. The transmitter Tx' comprises the first modulator SW1 and the power amplifier PA configured to generate the output signal V_{OUT}. The first modulator SW1 is activated from the first modulating signal PT having the first modulating frequency f1 that defines alternatively a state ON and a state OFF of the first modulator SW1.

The control block 10 comprises an estimator unit 14 that is configured to receive the carrier signal 2 during the time window ΔTx in order to define an estimated frequency variation Δf of the carrier signal 2 during first time intervals Tx_{ON} and during second time intervals Tx_{OFF}. In particular, the estimator unit 14 is configured to receive a signal clock which is the first modulating signal PT in order to define said first time intervals Tx_{ON} and said second time intervals Tx_{OFF}.

The control block 100 further comprises a compensation unit 160 having a logic unit 180 and a digital to analog current converter IDAC. The logic unit 180 is configured to define an output digital signal OUT_{n-bit} that is setting from the estimated frequency variation Δf. The digital to analog current converter IDAC is configured to receive the output digital signal OUT_{n-bit} and to generate the proportional pre-compensation current signal I'com having a current variation of [±0.5*(2ⁿ-1)*ΔI], wherein the ΔI is a predefined current step value.

The second modulator SW2 is configured to receive and modulate the pre-compensation current signal I'com by the second modulating signal PTosc in order to obtain the current compensation signal Icom. In particular, the second modulating signal PTosc has a second modulating frequency f2 that corresponds substantially to the first modulating frequency f1 of the first modulating signal PT. In particular, the second modulating signal PTosc is a signal having the same frequency of the first modulating signal PT with a different duty-cycle.

The transmitter Tx' further comprises an input bias terminal 4 coupled to a current generator 20 by a second adder 7, i.e. a current summing circuit, the current generator 20 being coupled to a reference voltage Vo and configured to generate the bias current signal I_{BIAS}. The reference voltage Vo being the ground voltage.

The adder 7 is configured to receive the current compensation signal Icom and the bias current signal I_{TUNE} and to generate a bias current adapted to tune the tunable frequency fₜ of the local oscillator 1 proportional to the estimated frequency variation Δf.

The receiver Rx is configured to receive the carrier signal 2 from the local oscillator 1 by an interposed terminal 31 coupled to the output terminal 3.

Furthermore, the receiver Rx is configured to receive the input signal V_{IN} that is amplified by the low-noise amplifier LNA and mixed with the carrier signal 2 and further demodulated by the demodulator DEM in order to generate an output data signal OUT. The demodulator DEM is driven by a demodulating signal PT_{N}, that is a complementary signal with respect to the first modulating signal PT having the same demodulating frequency f_{D} of the first modulating signal PT.

According to one embodiment, the transceiver 30 is implemented in a radar system wherein the estimated frequency variation Δf is low than 1 Mhz for the first modulating frequency (f1) of 24Ghz.

The disclosure refers also to a method to compensate the frequency pulling in an oscillator circuit, Tx or Tx', which comprises a local oscillator 1 that is operative to a tunable frequency fₜ. In the following description parts and details already described and having the same structure and function as above described will be identified by the same signs and reference numbers.

The oscillator circuit, Tx or Tx', comprises a first modulator SW1 and a power amplifier PA couple in cascade to the local oscillator 1 and configured to generate an output signal V_{OUT}. In particular, the power amplifiers PA and the local oscillator 1 are integrated in the same semiconductor substrate.

The method comprises:
- generating a carrier signal 2 by the local oscillator 1;
- modulating the carrier signal 2 by the first modulator SW1 with a first modulating signal PT having a first modulating frequency f1 by obtaining a modulated carrier signal 2';
- amplifying the modulated carrier signal 2' by the power amplifier PA in order to generate the output signal V_{OUT}, and
- transmitting the output signal V_{OUT} by a transmitting antenna 8.

According to the embodiment, the oscillator circuit is a transmitter Tx of a radar system and the carrier signal 2 and consequently the output signal V_{OUT} are radio frequency signals.

The first modulating signal PT has a first modulating frequency f1 that defines alternatively a state ON and a state OFF of the first modulator SW1.

The method further comprises:
- processing the carrier signal 2 during a time window ΔTx by a control block, 10 or 100; and
- estimating an estimated frequency variation Δf of the carrier signal 2 by an estimator unit 14 during first time intervals Tx_{ON} and during second time intervals Tx_{OFF} of said first modulating signal PT in said time window ΔTx.

In particular, the estimating comprises:
- providing the estimator unit 14 with a clock signal to define during said time window (ΔTx) first time intervals (Tx_{ON}) and second time intervals (Tx_{OFF});
- estimating a first estimated frequency F1_{ON} during said first time intervals Tx_{ON}; and
- estimating a second estimated frequency F2_{OFF} during said second time intervals Tx_{OFF};
- calculating the estimated frequency variation Δf as a difference between the first estimated frequency F1_{ON} and the second estimated frequency F2_{OFF}.

According to one embodiment, the method further comprises:
- providing the first modulating signal (PT) as the clock signal.

The method further comprises:
- generating a pre-compensation signal, V'com or I'com, setting from the estimated frequency variation Δf;
- modulating the pre-compensation signal, V'com or I'com, with a second modulating signal PTosc having substantially the same frequency f1 of the first modulating signal PT in order to obtain a compensation signal, Vcom or Icom;
- mixing the compensation signal, Vcom or Icom, to a bias signal, VTUNE or I_{TUNE}, of said local oscillator 1 for tuning said tunable frequency f1 in order to shift the phase of the carrier signal 2 output from the local oscillator 1.

According to one embodiment, the second modulating signal PTosc is a signal having the same frequency of the first modulating signal PT with a different duty-cycle.

In particular, the generating a pre-compensation signal, V'com or I'com, comprises:
- defining a logic state N of the local oscillator 1 by using a previous logic state N-1 of the local oscillator 1 obtained by a logic unit, 18 or 180, and elaborating the estimated frequency variation value Δf;
- generating an output digital signal OUT_{n-bit} by using the defined logic state N of the local oscillator 1;
- converting the output digital signal OUT_{n-bit} in the analog pre-compensation signal, V'com or I'com, having a proportional variation to the output digital signal OUT_{n-bit} by using a digital to analog converter, VDAC or IDAC.

According to one embodiment, the logic unit, 18 or 180, can be a Finite State Machine FSM.

In a dual mode, the analog pre-compensation signal, V'com or I'com, can be an analog pre-compensation voltage signal V'com or an analog pre-compensation current signal I'com in order to provide, respectively, a voltage compensation signal Vcom or a current compensation signal Ico.

According to a first embodiment, as shown in figure 3, the output digital signal OUT_{n-bit} is converted in the analog pre-compensation voltage signal V'com that has a proportional variation corresponding to [±0.5*(2ⁿ-1)*ΔV], wherein the ΔV is a predefined voltage step value.

Thus, the method comprises modulating the pre-compensation voltage signal V'com by the second modulating signal PTosc and mixing the voltage compensation signal Vcom to the voltage bias signal VTUNE of said local oscillator 1 by a first adder 6, i.e. a voltage summing unit, for tuning the tunable frequency f1 of the local oscillator 1.

The method comprises an initial calibration by adjusting the oscillator frequency of the local oscillator 1 in order to minimize the frequency deviation of the carrier signal 2, between first time intervals TX_{ON} and second time intervals TX_{OFF} of the first modulator SW1. So, the adjusting of the oscillator frequency of the local oscillator 1 is maintained during the operation of the local oscillator 1 for reducing the pulling frequency phenomenon.

According to a second embodiment, as shown in figure 4, dual with respect to the first embodiment, the output digital signal OUT_{n-bit} is converted in the analog pre-compensation current signal I'com that has a proportional variation corresponding to [±0.5*(2ⁿ-1)*ΔI], wherein the ΔI is a predefined current step value.

The method further comprises modulating the pre-compensation current signal I'com by the second modulating signal PTosc, and summing the compensation current signal Icom to the bias current signal I_{TUNE} of said local oscillator 1 by a second adder 7, i.e. a current summing unit, for tuning the tunable frequency f1 of the local oscillator 1.

The disclosure refers also to a method to compensate the frequency pulling in a transceiver, 30 or 300, comprising:
- providing a transmitter, Tx or Tx', as above described;
- generating a receiver Rx receiving the carrier signal 2 of the local oscillator 1 by an interposed terminal 31 coupled to an output terminal 3 of the local oscillator 1 and receiving an input signal V_{IN} by an input antenna 9.

The input signal V_{IN} being return signal, like an echo, of the output signal V_{OUT} transmitted from the transmitter Tx or Tx'.

The method further comprises:
- adding the input signal V_{IN} with the carrier signal 2, by using an adder 32 in order to obtain a receiving signal; and
- demodulating the receiving signal by using a demodulator switch DEM driven by a demodulator signal PT_{N} in order to generate an output data signal OUT.

In particular, the method comprises:
- providing the demodulator signal PT_{N} as a complementary signal with respect to the first modulating signal PT and having a demodulating frequency f_{D} that corresponds substantially to the first frequency f1 of the first modulating signal PT. The rectifying of the tunable frequency fₜ of the local oscillator 1 allows to reduce the frequency pulling phenomenon having the input signal V_{IN}, the output signal V_{OUT} and the currier signal 2 with the same frequency.

Having thus described at least one illustrative embodiment of the invention, various alterations, modifications, and improvements will readily occur to those skilled in the art. Accordingly, the foregoing description is by way of example only and is not intended as limiting. The invention is limited only as defined in the following claims and equivalents thereof.

### Experimental results

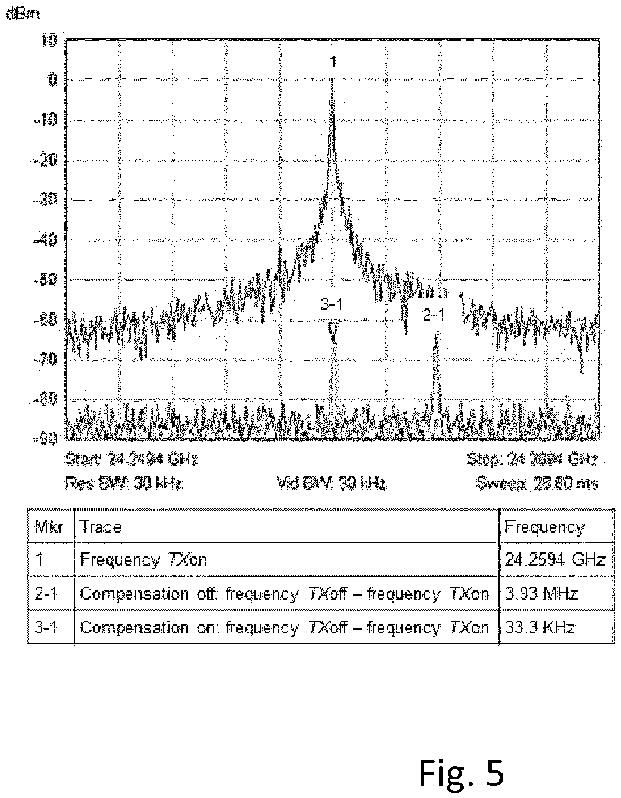

The experimental results, tested to the Applicant as shown in FIG. 5, have been acquired by using a spectrum analyzer and show the frequency pulling in case of the compensation circuit is used. In a system affected by a frequency pulling as high as 4 MHz, marker 2-1, the compensation circuit reduces the frequency pulling in the range of 35 kHz, marker 3-1.

## Claims

1. Oscillator circuit comprising a local oscillator (1) configured to generate a carrier signal (2) having a tunable frequency (fₜ), a first modulator (SW1) and a power amplifier (PA) couple in cascade to said local oscillator (1) and configured to generate an output signal (V_{OUT}), the first modulator (SW1) configured to be activated from a first modulating signal (PT) having a first modulating frequency (f1) defining alternatively states ON and states OFF of said first modulator (SW1),
**characterized by** comprising:
an estimator unit (14) configured to receive the carrier signal (2) during a time window (ΔTx) and to detect an estimated frequency variation (Δf) of said carrier signal (2) during the states ON with respect to the states OFF of said first modulator (SW1),
a compensation unit (16,160) comprising a second modulator (SW2) and configured to generate a compensation signal (Vcom, Icom) proportional to the estimated frequency variation (Δf) and modulated with a second modulating frequency (f2), the second modulating frequency (f2) being the same as the first modulating frequency (f1), the compensation signal (Vcom, Icom) being added to a bias signal (V_{TUNE},I_{BIAS}) of the local oscillator (1) to tune the tunable frequency (fₜ).

2. Oscillator circuit according to claim 1 **characterized in that** the compensation unit (16, 160) comprises a logic unit (18, 180) coupled to a second modulator (SW2), the logic unit (18, 180) being configured to receive the estimated frequency variation (Δf) and to define a pre-compensation signal (I'com, V'com), the second modulator (SW2) configured to modulate the pre-compensation signal (I'com, V'com) by a second modulating signal (PTosc) having the second modulating frequency (f2).

3. Oscillator circuit according to claim 2 **characterized in that** the logic unit (18, 180) is configured to generate an output digital signal (OUTₙ₋bit) and **in that** the compensation unit (16, 160) further comprises a digital to analog converter (IDAC, VDAC) configured to receive the output digital signal (OUTₙ₋bit) and to generate the pre-compensation signal (I'com, V'com).

4. Oscillator circuit according to claim 1 **characterized in that** the local oscillator (1) comprises an input terminal (5) coupled to a voltage source (8) by a first adder (6), the first adder (6) being configured to generate a voltage compensation signal (Vcom) by summing the bias voltage signal (V_{TUNE}) generated by the voltage source (8) and the voltage compensation signal (Vcom) generated by the compensation unit (16).

5. Oscillator circuit according to claim 1 **characterized in that** the local oscillator (1) comprises an input bias terminal (4) coupled to a current source (20) by a second adder (7), the second adder (7) being configured to generate a current compensation signal by summing the bias current signal (I_{BIAS}) generated by the current source (20) and the current compensation signal (Icom) generated by the compensation unit (160).

6. Oscillator circuit according to claim 1 **characterized in that** the compensation unit (16, 160) comprises a Finite State Machine.

7. A transceiver comprising a transmitter (Tx, Tx') and a receiver (Rx) **characterized in that** the transmitter (Tx, Tx') is configured according to one or more of previous claims 1 to 6 and **in that** the receiver (Rx) comprises a low-noise amplifier (LNA) coupled to a demodulator (DEM) with an interposed adder (32), the interposed adder (32) being configured to receive the carrier signal (2) and being coupled to the demodulator (DEM) driven by a demodulating signal (PT_{N}), said demodulating signal (PT_{N}) having the same frequency (f1) of the first modulating signal (PT) and being a complementary signal with respect to the first modulating signal (PT).

8. A transceiver (30, 300) according to claim 7 **characterized in that** is implemented in a radar system wherein the estimated frequency variation (Δf) is lower than 1 Mhz for the first modulating frequency (f1) of 24Ghz.

9. Method to compensate the frequency pulling in an oscillator circuit comprising:
- generating a carrier signal (2) by a local oscillator (1) operative to a tunable frequency (fₜ);
- modulating the carrier signal (2) with a first modulating signal (PT) having a first frequency (f1) by obtaining a modulated carrier signal (2') and amplifying the modulated carrier signal (2') to generate an output signal (V_{OUT}); **characterized by**
- processing the carrier signal (2) in a time window (ΔTx) and with a clock signal to define during said time window (ΔTx) first time intervals (Tx_{ON}) and second time intervals (Tx_{OFF});
- estimating a first estimated frequency (F1_{ON}) during said first time intervals (Tx_{ON}) and a second estimated frequency (F2_{OFF}) during said second time intervals (Tx_{OFF});
- calculating an estimating frequency variation (Δf) of said carrier signal (2) as a difference between said first estimated frequency (F1_{ON}) and said second estimated frequency (F2_{OFF});
- generating a pre-compensation signal (I'com, V'com) setting from the estimated frequency variation value (Δf);
- modulating the pre-compensation signal (I'com, V'com) with a second modulating signal (PTosc) by obtaining a compensation signal (Icom, Vcom), said second modulating signal (PTosc) having the same frequency (f1) as the first modulating signal (PT),
- adding the compensation signal (Icom, Vcom) to a bias signal (V_{TUNE},I_{BIAS}) of said local oscillator (1) for tuning said tunable frequency (f1).

10. Method according to claim 9 **characterized in that** the processing of the carrier signal (2) comprises:
- providing the first modulating signal (PT) as said clock signal; defining a logic state (N) of the local oscillator (1) by using a previous logic state (N-1) of the local oscillator (1) and by elaborating the estimated frequency variation value (Δf)
- generating an output digital signal (OUT_{n-bit}) by using the defined logic state (N) of the local oscillator (1) ;
- converting the output digital signal (OUT_{n-bit}) in an analog pre-compensation signal (I'com, V'com).

11. Method to compensate the frequency pulling in a transceiver (30, 300), **characterized by** comprising:
- generating a transmitter (Tx, Tx') according to claim 9 or 10 and generating a receiver (Rx) receiving an input signal (V_{IN}) and the carrier signal (2) generated by the local oscillator (1) for generating a receiving signal; and
- demodulating the receiving signal by using a demodulator switch (DEM) driven by a demodulating signal (PT_{N}),
- providing the demodulating signal (PT_{N}) having the same frequency (f1) of the first modulating signal (PT) and being a complementary signal with respect to the first modulating signal (PT).

## Patentansprüche

1. Oszillatorschaltung, aufweisend einen Lokaloszillator (1), der dazu konfiguriert ist, ein Trägersignal (2) mit einer abstimmbaren Frequenz (fₜ) zu erzeugen, einen ersten Modulator (SW1) und einen Leistungsverstärker (PA) in Kaskade mit dem Lokaloszillator (1) koppeln und dazu konfiguriert sind, ein Ausgangssignal (V_{OUT}) zu erzeugen, wobei der erste Modulator (SW1) dazu konfiguriert ist, von einem ersten modulierenden Signal (PT) mit einer ersten modulierenden Frequenz (f1), das abwechselnd Zustände AN und Zustände AUS des ersten Modulators (SW1) definiert, aktiviert zu werden,
**gekennzeichnet durch** das Aufweisen von:
einer Schätzereinheit (14), die dazu konfiguriert ist, das Trägersignal (2) während eines Zeitfensters (ΔTx) zu empfangen und eine geschätzte Frequenzvariation (Δf) des Trägersignals (2) während der Zustände AN bezogen auf die Zustände AUS des ersten Modulators (SW1) zu detektieren,
eine Kompensationseinheit (16, 160), die einen zweiten Modulator (SW2) aufweist und dazu konfiguriert ist, ein zu der geschätzten Frequenzvariation (Δf) proportionales und mit einer zweiten modulierenden Frequenz (f2) moduliertes Kompensationssignal (Vcom, Icom) zu erzeugen, wobei die zweite modulierende Frequenz (f2) die gleiche wie die erste modulierende Frequenz (f1) ist, wobei das Kompensationssignal (Vcom, Icom) zu einem Bias-Signal (V_{TUNE}, I_{BIAS}) des Lokaloszillators (1) addiert wird, um die abstimmbare Frequenz (fₜ) abzustimmen.

2. Oszillatorschaltung nach Anspruch 1, **dadurch gekennzeichnet, dass** die Kompensationseinheit (16, 160) eine mit einem zweiten Modulator (SW2) gekoppelte Logikeinheit (18, 180) aufweist, wobei die Logikeinheit (18, 180) dazu konfiguriert ist, die geschätzte Frequenzvariation (Δf) zu empfangen und ein Vorkompensationssignal (I'com, V'com) zu definieren, wobei der zweite Modulator (SW2) dazu konfiguriert ist, das Vorkompensationssignal (I'com, V'com) durch ein zweites modulierendes Signal (PT_{OSC}), das die zweite Modulationsfrequenz (f2) aufweist, zu modulieren.

3. Oszillatorschaltung nach Anspruch 2, **dadurch gekennzeichnet, dass** die Logikeinheit (18, 180) dazu konfiguriert ist, ein ausgegebenes Digitalsignal (OUT_{n-bit}) zu erzeugen, und dadurch, dass die Kompensationseinheit (16, 160) ferner einen Digital-Analog-Wandler (IDAC, VDAC) aufweist, der zum Empfangen des ausgegebenen Digitalsignals (OUT_{n-bit}) und zum Erzeugen des Vorkompensationssignals (I'com, V'com) konfiguriert ist.

4. Oszillatorschaltung nach Anspruch 1, **dadurch gekennzeichnet, dass** der Lokaloszillators (1) einen Eingangsanschluss (5) aufweist, der mit einer Spannungsquelle (8) mittels eines ersten Addierers (6) gekoppelt ist, wobei der erste Addierer (6) dazu konfiguriert ist, ein Spannungskompensationssignal (Vcom) durch Addieren des von der Spannungsquelle (8) erzeugten Bias-Spannungssignals (V_{TUNE}) und des von der Kompensationseinheit (16) erzeugten Spannungskompensationssignals (Vcom) zu erzeugen.

5. Oszillatorschaltung nach Anspruch 1, **dadurch gekennzeichnet, dass** der Lokaloszillators (1) einen Eingangs-Bias-Anschluss (4) aufweist, der mit einer Stromquelle (20) mittels eines zweiten Addierers (7) gekoppelt ist, wobei der zweite Addierer (7) dazu konfiguriert ist, ein Stromkompensationssignal durch Addieren des von der Stromquelle (20) erzeugten Bias-Stromsignals (I_{BIAS}) und des von der Kompensationseinheit (160) erzeugten Stromkompensationssignals (Icom) zu erzeugen.

6. Oszillatorschaltung nach Anspruch 1, **dadurch gekennzeichnet, dass** die Kompensationseinheit (16, 160) einen endlichen Automaten aufweist.

7. Transceiver, aufweisend einen Sender (Tx, Tx') und einen Empfänger (Rx), **dadurch gekennzeichnet, dass** der Sender (Tx, Tx') nach einem oder mehreren der vorhergehenden Ansprüche 1 bis 6 ausgebildet ist, und dadurch, dass der Empfänger (Rx) einen rauscharmen Verstärker (LNA) aufweist, der mit einem Demodulator (DEM) mit einem zwischengeschalteten Addierer (32) gekoppelt ist, wobei der zwischengeschaltete Addierer (32) zum Empfangen des Trägersignals (2) konfiguriert ist und mit dem von einem demodulierenden Signal (PT_{N}) angesteuerten Demodulator (DEM) gekoppelt ist, wobei das demodulierende Signal (PT_{N}) die gleiche Frequenz (f1) des ersten modulierenden Signals (PT) hat und ein Komplementärsignal bezogen auf das erste modulierende Signal (PT) ist.

8. Transceiver (30, 300) nach Anspruch 7, **dadurch gekennzeichnet, dass** er in einem Radarsystem implementiert ist, wobei die geschätzte Frequenzvariation (Δf) kleiner als 1 MHz für die erste modulierende Frequenz (f1) von 24 GHz ist.

9. Verfahren zur Kompensation des Mitzieheffekts in einer Oszillatorschaltung, das aufweist:
- das Erzeugen eines Trägersignals (2) durch einen Lokaloszillator (1), betriebsfähig bei einer abstimmbaren Frequenz (fₜ);
- das Modulieren des Trägersignals (2) mit einem ersten modulierenden Signal (PT), das eine erste Frequenz (f1) aufweist, mittels Erhalten eines modulierten Trägersignals (2') und Verstärken des modulierten Trägersignals (2') zum Erzeugen eines Ausgangssignals (V_{OUT}); **gekennzeichnet durch**
- das Verarbeiten des Trägersignals (2) in einem Zeitfenster (ΔTx) und mit einem Taktsignal zum Definieren während des Zeitfensters (ΔTx) von ersten Zeitintervallen (Tx_{ON}) und zweiten Zeitintervallen (Tx_{OFF});
- das Schätzen einer ersten geschätzten Frequenz (F1_{ON}) während der ersten Zeitintervalle (Tx_{ON}) und einer zweiten geschätzten Frequenz (F2_{OFF}) während der zweiten Zeitintervalle (Tx_{OFF});
- das Berechnen einer geschätzten Frequenzvariation (Δf) des Trägersignals (2) als eine Differenz zwischen der ersten geschätzten Frequenz (F1_{ON}) und der zweiten geschätzten Frequenz (F2_{OFF});
- das Erzeugen einer Vorkompensationssignal-(I'com, V'com)-Einstellung aus dem Wert (Δf) der geschätzten Frequenzvariation;
- das Modulieren des Vorkompensationssignals (I'com, V'com) mit einem zweiten modulierenden Signal (PT_{OSC}) indem ein Kompensationssignal (Icom, Vcom) erhalten wird, wobei das zweite modulierende Signal (PT_{OSC}) die gleiche Frequenz (f1) wie das erste modulierende Signal (PT) hat,
- das Addieren des Kompensationssignals (Icom, Vcom) zu einem Bias-Signal (V_{TUNE}, I_{BIAS}) des Lokaloszillators (1) zum Abstimmen der abstimmbaren Frequenz (f1).

10. Verfahren nach Anspruch 9, **dadurch gekennzeichnet, dass** das Verarbeiten des Trägersignals (2) aufweist:
- das Bereitstellen des ersten modulierenden Signals (PT) als das Taktsignal; das Definieren eines Logikzustands (N) des Lokaloszillators (1) durch Verwenden eines vorherigen Logikzustands (N-1) des Lokaloszillators (1) und durch Ausarbeiten des Werts (Δf) der geschätzten Frequenzvariation
- das Erzeugen eines digitalen Ausgangssignals (OUT_{n-bit}) durch Verwenden des definierten Logikzustands (N) des Lokaloszillators (1);
- das Umwandeln des digitalen Ausgangssignals (OUT_{n-bit}) in ein analoges Vorkompensationssignal (I'com, V'com).

11. Verfahren zur Kompensation des Mitzieheffekts in einem Transceiver (30, 300), **dadurch gekennzeichnet, dass** es aufweist:
- das Generieren eines Senders (Tx, Tx') nach Anspruch 9 oder 10 und das Generieren eines Empfängers (Rx), der ein Eingangssignal (V_{IN}) und das durch den Lokaloszillator (1) erzeugte Trägersignal (2) zum Erzeugen eines Empfangssignals empfängt; und
- das Demodulieren des Empfangssignals durch Verwenden eines Demodulator-Schalters (DEM), der durch ein demodulierendes Signal (PT_{N}) angesteuert wird,
- das Bereitstellen des demodulierenden Signals (PT_{N}), das die gleiche Frequenz (f1) des ersten modulierenden Signals (PT) hat und ein Komplementärsignal bezogen auf das erste modulierende Signal (PT) ist.

## Revendications

1. Circuit oscillateur comprenant un oscillateur local (1) conçu pour générer un signal de porteuse (2) ayant une fréquence réglable (fₜ), un premier modulateur (SW1) et un amplificateur de puissance (PA) couple en cascade audit oscillateur local (1) et conçu pour générer un signal de sortie (V_{OUT}), le premier modulateur (SW1) est conçu pour être activé à partir d'un premier signal de modulation (PT) ayant une première fréquence de modulation (f1) définissant en variante des états de marche et des états d'arrêt dudit premier modulateur (SW1),
**caractérisé en ce qu**'il comprend :
une unité d'estimation (14) conçue pour recevoir le signal de porteuse (2) pendant une fenêtre temporelle (ΔTx) et pour détecter une variation de fréquence estimée (Δf) dudit signal de porteuse (2) pendant les états de marche par rapport aux états d'arrêt dudit premier modulateur (SW1),
une unité de compensation (16, 160) comprenant un second modulateur (SW2) et conçue pour générer un signal de compensation (Vcom, Icom) proportionnel à la variation de fréquence estimée (Δf) et modulé avec une seconde fréquence de modulation (f2), la seconde fréquence de modulation (f2) étant la même que la première fréquence de modulation (f1), le signal de compensation (Vcom, Icom) étant ajouté à un signal de polarisation (V_{TUNE}, I_{BIAS}) de l'oscillateur local (1) pour régler la fréquence réglable (fₜ).

2. Circuit oscillateur selon la revendication 1
**caractérisé en ce que** l'unité de compensation (16, 160) comprend une unité logique (18, 180) couplée à un second modulateur (SW2), l'unité logique (18, 180) étant conçue pour recevoir la variation de fréquence estimée (Δf) et pour définir un signal de pré-compensation (I'com, V'com), le second modulateur (SW2) est conçu pour moduler le signal de pré-compensation (I'com, V'com) grâce à un second signal de modulation (PTosc) ayant la seconde fréquence de modulation (f2).

3. Circuit oscillateur selon la revendication 2
**caractérisé en ce que** l'unité logique (18, 180) est conçue pour générer un signal numérique sorti (OUT_{n-bit}) et **en ce que** l'unité de compensation (16, 160) comprend en outre un convertisseur analogique-numérique (IDAC, VDAC) conçu pour recevoir le signal numérique sorti (OUT_{n-bit}) et pour générer le signal de pré-compensation (I'com, V'com).

4. Circuit oscillateur selon la revendication 1
**caractérisé en ce que** l'oscillateur local (1) comprend une borne d'entrée (5) couplée à une source de tension (8) par un premier additionneur (6), le premier additionneur (6) étant conçu pour générer un signal de compensation de tension (Vcom) en faisant la somme du signal de tension de polarisation (V_{TUNE}) généré par la source de tension (8) et du signal de compensation de tension (Vcom) généré par l'unité de compensation (16).

5. Circuit oscillateur selon la revendication 1
**caractérisé en ce que** l'oscillateur local (1) comprend une borne de polarisation d'entrée (4) couplée à une source de courant (20) par un second additionneur (7), le second additionneur (7) étant conçu pour générer un signal de compensation de courant en faisant la somme du signal de courant de polarisation (I_{BIAS}) généré par la source de courant (20) et du signal de compensation de courant (Icom) généré par l'unité de compensation (160).

6. Circuit oscillateur selon la revendication 1
**caractérisé en ce que** l'unité de compensation (16, 160) comprend une machine à états finis.

7. Émetteur-récepteur comprenant un émetteur (Tx, Tx') et un récepteur (Rx) **caractérisé en ce que** l'émetteur (Tx, Tx') est conçu selon une ou plusieurs des revendications 1 à 6 précédentes et **en ce que** le récepteur (Rx) comprend un amplificateur de bruit faible (LNA) couplé à un démodulateur (DEM) avec un additionneur interposé (32), l'additionneur interposé (32) étant conçu pour recevoir le signal de porteuse (2) et étant couplé au démodulateur (DEM) commandé par un signal de démodulation (PT_{N}), ledit signal de démodulation (PT_{N}) ayant la même fréquence (f1) du premier signal de modulation (PT) et étant un signal complémentaire par rapport au premier signal de modulation (PT).

8. Émetteur-récepteur (30, 300) selon la revendication 7 **caractérisé en ce qu**'il est implémenté dans un système radar dans lequel la variation de fréquence estimée (Δf) est inférieure à 1 Mhz pour la première fréquence de modulation (f1) de 24 Ghz.

9. Procédé permettant de compenser l'entraînement de fréquence dans un circuit oscillateur comprenant les étapes consistant à :
- générer un signal de porteuse (2) par un oscillateur local (1) opérationnel pour une fréquence réglable (ft) ;
- moduler le signal de porteuse (2) avec un premier signal de modulation (PT) ayant une première fréquence (f1) en obtenant un signal de porteuse modulé (2') et en amplifiant le signal de porteuse modulé (2') pour générer un signal de sortie (V_{OUT}) ; **caractérisé par** les étapes consistant à :
- traiter le signal de porteuse (2) dans une fenêtre temporelle (ΔTx) et avec un signal d'horloge pour définir pendant ladite fenêtre temporelle (ΔTx) des premiers intervalles temporels (Tx_{ON}) et des seconds intervalles temporels (TX_{OFF}) ;
- estimer une première fréquence estimée (F1_{ON}) pendant lesdits premiers intervalles temporels (Tx_{ON}) et une seconde fréquence estimée (F2_{OFF}) pendant lesdits seconds intervalles temporels (Tx_{OFF}) ;
- calculer une variation de fréquence d'estimation (Δf) dudit signal de porteuse (2) comme une différence entre ladite première fréquence estimée (F1_{ON}) et ladite seconde fréquence estimée (F2_{OFF}) ;
- générer un signal de pré-compensation (I'com, V'com) par un réglage à partir de la valeur de variation de fréquence estimée (Δf) ;
- moduler le signal de pré-compensation (I'com, V'com) avec un second signal de modulation (PTosc) en obtenant un signal de compensation (Icom, Vcom), ledit second signal de modulation (PTosc) ayant la même fréquence (f1) que le premier signal de modulation (PT),
- ajouter le signal de compensation (Icom, Vcom) à un signal de polarisation (V_{TUNE}, I_{BIAS}) dudit oscillateur local (1) pour régler ladite fréquence réglable (f1).

10. Procédé selon la revendication 9 **caractérisé en ce que** le traitement du signal de porteuse (2) comprend les étapes consistant à :
- fournir le premier signal de modulation (PT) comme ledit signal d'horloge ; définir un état de logique (N) de l'oscillateur local (1) en utilisant un état de logique précédent (N-1) de l'oscillateur local (1) et en élaborant la valeur de variation de fréquence estimée (Δf) ;
- générer un signal numérique de sortie (OUT_{n-bit}) en utilisant l'état logique défini (N) de l'oscillateur local (1) ;
- convertir le signal numérique de sortie (OUT_{n-bit}) en un signal de pré-compensation (I'com, V'com) analogique.

11. Procédé permettant de compenser l'entraînement de fréquence dans un émetteur-récepteur (30, 300) **caractérisé en ce qu**'il comprend les étapes consistant à :
- générer un émetteur-récepteur (Tx, Tx') selon la revendication 9 ou 10 et générer un récepteur (Rx) recevant un signal d'entrée (V_{IN}) et le signal de porteuse (2) généré par l'oscillateur local (1) permettant de générer un signal de réception ; et
- démoduler le signal de réception en utilisant un commutateur de démodulation (DEM) commandé par un signal de démodulation (PT_{N}),
- fournir le signal de démodulation (PT_{N}) ayant la même fréquence (f1) du premier signal de modulation (PT) et étant un signal complémentaire par rapport au premier signal de modulation (PT).
